# EUROPEAN PATENT SPECIFICATION

(11) **EP 3 308 404 B1**
(45) Date of publication and mention of the grant of the patent: **08.07.2020**
(21) Application number: 16733184.2
(22) Date of filing: 08.06.2016
(51) Int. Cl.: H01L 31/0392, H01L 31/046

(54) **METHOD OF DECREASING CRACK PROPAGATION DAMAGE IN A SOLAR CELL DEVICE**
VERFAHREN ZUR VERMINDERUNG DER RISSAUSBREITUNG BEI EINER SOLARZELLENVORRICHTUNG
PROCÉDÉ DE DIMINUTION DES DOMMAGES DE PROPAGATION DE FISSURES DANS UN DISPOSITIF DE CELLULE SOLAIRE

(30) Priority: 12.06.2015 US 201562174987 P
(43) Date of publication of application: 18.04.2018
(73) Proprietor: Flisom AG, 8155 Niederhasli (CH)
(72) Inventor: MEEDER, Alexander, 14195 Berlin (DE); ZILTENER, Roger, 6210 Sursee (CH); NETTER, Thomas, CH-8400 Winterthur (CH)
(86) International application number: PCT/IB2016/000778
(87) International publication number: WO 2016/198939

(56) References cited:
- US-A- 6 013 873
- US-A1- 2009 272 434
- US-A1- 2012 073 645

## Description

### BACKGROUND

### Field

Embodiments of the present disclosure generally relate to a monolithic optoelectronic device, such as photovoltaic modules, and more particularly to flexible photovoltaic modules.

### Description of the Related Art

Thin-film photovoltaic modules, a variety of which is also known as thin-film solar modules, are generally composed of a number of electrically interconnected optoelectronic components. Such components may be optoelectronic devices such as photovoltaic cells and additional optional components such as diodes and other electronic devices. Photovoltaic modules usually also include electrically interconnecting components such as cell-to-cell connectors and busbars.

US2012/0073645 and US6013873 disclose thin-film photovoltaic modules.

Multilayer thin-film technologies enable the monolithic integration and interconnection of several optoelectronic components and associated components on a same substrate. This integration is produced in-situ using a sequence of layer deposition and scribing techniques. Thin-film optoelectronic or photovoltaic components or devices are essentially composed of a stack of three material layers: a conducting back-contact electrode layer, a semiconductive photovoltaic material layer (or absorber layer), and a conducting front-contact electrode layer, which is usually optically transparent. Photovoltaic cells based on semiconductive material, such as Cu(In,Ga)Se₂ (CIGS), CdTe, or perovskites show a high potential for less expensive solar electricity, lower energy payback time, and improved life-cycle impact as compared to traditional wafer-based silicon photovoltaic devices or solar cells.

Compared to wafer-based photovoltaic devices, monolithic photovoltaic modules may have lower costs thanks to reduced material quantities used by thin films, reduced labor costs of monolithic integration, and ease of automatic production of large quantities of photovoltaic modules, for example using roll-to-roll manufacturing techniques.

However, one problem in the field of manufacturing of thin-film photovoltaic modules via roll-to-roll processing is the layer stress anisotropy in the thin film layers (e.g. metallic contact layers and semiconductor layers) formed on the flexible substrates used in roll-to-roll manufacturing processes. This can lead to stress relaxation effects, especially at the edges of the web, which can cause the cross-web edges (e.g., perpendicular to web transfer direction) to bend up or down relative to the center of the web. Also, cracking can be observed in the deposited thin-film layers, due to the intrinsic or extrinsic stress found in these deposited layers. Cracks may result from stresses within layers resulting from non-uniform heating of the web during the thin-film deposition processes. It is known that cracks or defects that are formed in the thin-film layers will continue to grow until all of the stress in the film is released. These generated cracks typically start at the web edges, and especially at locations in the deposited layer stack that contain defects or micro-scratches. In standard web transportation systems it is common for the web edges to be constrained to assure that a flexible web material does not wrinkle or warp during the deposition process. The act of constraining the edges of the web will typically create scratches and/or induce defects due to the mechanical handling of the edges of the web. Similar defects have also been found in other substrate manufacturing processing of other types of substrates, including glass substrates.

The cracks generated by an induced stress and/or by mechanical handling typically evolve and/or propagate to a point several centimeters into the so called "active region" of the solar module leading to severe mechanical damage, performance reduction, device shunting or other detrimental effects on photovoltaic module life-time.

Therefore, there is a need for a method of forming and a photovoltaic module that is able to overcome the problems described above.

### SUMMARY

Embodiments of the present disclosure may include a thin-film optoelectronic module device as defined by the subject-matter of claim 1 that comprises a substrate that has an edge that extends in a first direction, an active region and an edge region that is disposed between the edge and the active region, a semiconductive photovoltaic layer, and a conductive back-contact layer that is disposed between the substrate and the semiconductive photovoltaic layer. The conductive back-contact layer may be disposed within at least a portion of the active region and the edge region, and the conductive back-contact layer may include a plurality of isolating back-contact grooves that are aligned in a second direction and are disposed within the active region, wherein the second direction is at an angle to the first direction. The one or more scribe lines are aligned in the first direction, and are disposed within the edge region that is adjacent to the edge of the substrate. The thin-film optoelectronic module device may further include a plurality of active region scribe lines that are formed in the conductive back-contact layer and aligned in a spaced apart relationship that is parallel to the first direction, wherein the active region scribe lines are positioned within the active region, and cross the one or more scribe lines.

Embodiments of the present disclosure may also include a method of forming a thin-film optoelectronic module device as defined by the subject-matter of claim 6, comprising depositing a conductive back-contact layer on a substrate, wherein the formed conductive back-contact layer is disposed over at least a portion of an active region and an edge region of the substrate, and the edge region is disposed between the active region and an edge of the substrate. Then forming a plurality of isolating back-contact grooves, which are aligned in a second direction, within the active region of the deposited conductive back-contact layer, wherein the second direction is at an angle to the first direction. Then forming one or more scribe lines, which are aligned in the first direction, within the edge region of the deposited conductive back-contact layer, and then depositing a semiconductive photovoltaic layer over the conductive back-contact layer.

### BRIEF DESCRIPTION OF THE DRAWINGS

So that the manner in which the above recited features of the present disclosure can be understood in detail, a more particular description of the disclosure, briefly summarized above, may be had by reference to embodiments, some of which are illustrated in the appended drawings. It is to be noted, however, that the appended drawings illustrate only exemplary embodiments and are therefore not to be considered limiting of its scope, may admit to other equally effective embodiments.
Figure 1A is a side cross-sectional view that illustrates a portion of a photovoltaic cell, according to an embodiment of the disclosure.
Figures 1B-1G are side cross-sectional views that illustrate portions of a photovoltaic module comprising monolithically-interconnected photovoltaic cells during different stages of a photovoltaic module fabrication process, according to an embodiment of the disclosure.
Figure 2A is an isometric view of a patterned portion of a photovoltaic cell 100, according to an embodiment of the disclosure provided herein.
Figure 2B is a plan view of a patterned portion of a photovoltaic cell 100, according to an embodiment of the disclosure provided herein.
Figure 3 is a close-up view of a portion of the photovoltaic cell illustrated in Figure 2B, according to an embodiment of the disclosure provided herein.
Figure 4 is a plan view of a patterned portion of a photovoltaic cell, according to an embodiment of the disclosure provided herein.
Figures 5A-5C are plan views of one or more scribe lines that are formed in one or more layers of a photovoltaic cell, according to an embodiment of the disclosure.
Figure 6 is an isometric view of a solar panel mounted on rails, according to an embodiment of the disclosure.

To facilitate understanding, identical reference numerals have been used, where possible, to designate identical elements that are common to the figures. It is contemplated that elements and features of one embodiment may be beneficially incorporated in other embodiments without further recitation.

### DETAILED DESCRIPTION

The present disclosure generally relates to a photovoltaic device, and method of forming the same that has an improved manufacturing device yield and desirable electrical properties based one or more patterning techniques performed during the photovoltaic device manufacturing process. The patterning techniques include forming one or more scribed regions in a formed or partially formed photovoltaic device to inhibit the migration of cracks or defects to undesirable regions of the formed photovoltaic device and/or reduce or relieve an amount of stress found in the layers used to form the photovoltaic device. As noted above, the generated cracks or defects are typically formed at in the edge regions of a photovoltaic device, and especially at locations in the deposited layer stack that contain defects or micro-scratches.

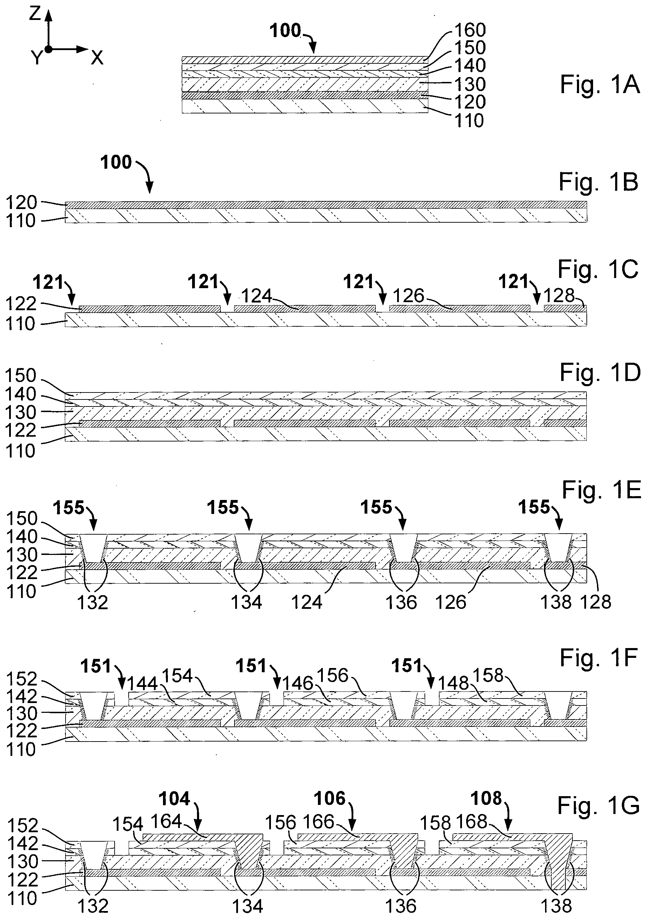

Figure 1A illustrates a side cross-sectional view of a portion of a thin-film optoelectronic module device, which is less formally referred to hereafter as a thin-film photovoltaic cell 100 or photovoltaic cell 100. Figure 1A is presented herein to provide an example of a layered structure of a typical photovoltaic device that may benefit from one or more of the patterning techniques described herein. To form the thin-film photovoltaic cell 100, a sequence of material layers are deposited on a substrate 110. Substrate 110 may be rigid or flexible, and be formed from a variety of materials or coated materials such as glass, coated metal, plastic-coated metal, plastic, or coated plastic such as metal-coated plastic. The inventive method and device, which are described herein, are especially advantageous when used in conjunction with flexible substrate materials, such as thin plastic and/or metal substrates. A preferred flexible substrate material is polyimide as it is flexible, sustains temperatures required to manufacture high efficiency optoelectronic modules, requires less processing than metal substrates, and exhibits thermal expansion coefficients that are compatible with those of material layers deposited upon it. Industrially available polyimide substrates are ordinarily available in thicknesses ranging from 7 micrometers (µm) to 150 µm.

An example of a process sequence used to form one or more thin-film photovoltaic cells 100 follows. Figures 1B through 1G are cross-sectional views that depict an example of a method or process of fabricating a monolithic type thin-film photovoltaic module, which includes the thin-film photovoltaic cell 100 that is partially depicted in Figure 1A. The process generally includes a sequence of material layer deposition, scribing and front-contact grid deposition steps. The overall thickness of thin-film material deposited onto the module's substrate 110 is typically about 3 to 5 micrometers (µm). In one example, the process of fabricating a monolithic type thin-film photovoltaic module includes forming thin film layers on a roll-to-roll type substrate that extends lengthwise in the plus or minus X-direction. The purpose of this initial description is to provide context within which one or more of various embodiments of the disclosure described herein, which will be discussed in detail later, can be added to a photovoltaic manufacturing process, and thus is not intended to be limiting as to the scope of the invention provided herein.

Referring to Figure 1B, the substrate 110 is coated with at least one electrically conductive layer 120. The electrically conductive layer, or stack of electrically conductive layers, also known as the back-contact, may be of a variety of electrically conductive materials, preferably having a coefficient of thermal expansion (CTE) that is close both to that of the substrate 110 and to that of other materials that are to be subsequently deposited upon it. Conductive layer 120 preferably has a high optical reflectance. In ordinary practice, layer 120 is deposited in a process such as sputtering, electrodeposition, chemical vapor deposition, physical vapor deposition, electron beam evaporation, or spraying and is commonly made of molybdenum (Mo) although several other thin-film materials such as metal chalcogenides, molybdenum chalcogenides, molybdenum selenides (such as MoSe₂), transition metal chalcogenides, tin-doped indium oxide (ITO), doped or non-doped indium oxides (such as In₂0₃), doped or non-doped zinc oxides, zirconium nitrides, tin oxides, titanium nitrides, titanium (Ti), tungsten (W), tantalum (Ta), and niobium (Nb) may also be used or included advantageously. Due to constraints on the maximum deposition temperature that is allowable for use with most flexible substrate materials (e.g., polyimide) and the high melting point of most compatible conductive layer 120 materials (e.g., Mo) the stress in the deposited conductive layer can be quite high.

Figure 1C illustrates a process step in which isolating back-contact grooves, referred to hereafter as grooves 121, are formed or cut into the back-contact layer 120, so as to expose at least one continuous line of the substrate in the plus and minus Y-directions, thereby providing a set of first back-contact components 122, 124, 126 and a respective corresponding set of second back-contact components 124, 126, 128 that are electrically isolated and disconnected from each other. The process step is often referred to herein as a scribing or patterning step P1. The patterning step P1 may be done using a mechanical scribe, such as a mechanical blade or a nanometer or picometer wavelength pulsed laser. Except for back-contact components 122, 128 situated at module extremities, other back-contact components 124, 126 are preferably of equal area and shape.

Figure 1D represents the next process step where at least one of the semiconductive photovoltaic layers 130, also known as the absorber layer, is deposited onto the back-contact components, thereby also filling grooves 121 of Figure 1C. The semiconductive photovoltaic layer 130 is preferably made of CdTe or of an ABC₂ material, wherein "A" represents elements in group 11 of the periodic table of chemical elements, such as copper (Cu) or silver (Ag), "B" represents elements in group 13 of the periodic table including indium (In), gallium (Ga), and/or aluminum (Al), and "C" represents elements in group 16 of the periodic table including sulfur (S), selenium (Se), or tellurium (Te). A preferred semiconductive photovoltaic layer is for example of the so-called CIGS type layer, thereby containing Cu, In, Ga, and Se₂. The semiconductive photovoltaic layer 130 may be deposited using a variety of techniques such as electrodeposition, printing, or vapor deposition.

Subsequently, substantially transparent layers include a so-called semiconductive buffer layer 140, for example made of CdS or ZnS material, and a front-contact conductive oxide (TCO) layer 150, for example made of ZnO:AI material or of tin-doped indium oxide (ITO) material are formed over the semiconductive photovoltaic layer 130. The semiconductive buffer layer 140 and front-contact conductive oxide layer 150 may each be formed using one or more conventional deposition techniques, such as a sputtering process, screen printing process, CVD process or wet chemical deposition technique.

Figure 1E represents the process step where via hole rows are scribed, such as the cell-to-cell vias 155. The process step where via hole rows 155 are drilled or scribed, preferably with a laser (e.g., nanometer or picometer wavelength pulsed laser), is referred to as scribing or patterning step P2. In some embodiments, cell-to-cell vias 155 are drilled with the objective of establishing a serial interconnection between what will, at the end of the manufacturing process, be a first cell, for example cell 104, and a second cell, for example cell 106. For each of the second back-contact components 124, 126, at least one cell-to-cell via hole 155 is drilled through the conductive front-contact layer 150 and through the semiconductive active layers 130, such that the cell-to-cell via hole 155 is deep enough to expose part of at least one of the second back-contact components 124, 126. In some embodiments, the heat produced along the surface of the cell-to-cell via hole 155 when being drilled causes a permanent change in the chemical composition of the surface within the semiconductive layers 130, 140, therein causing a surface metallization 132, 134, 136, 138. In this case, the surface of the cell-to-cell via hole 155 will become electrically conductive, thereby establishing an electrical path between the conductive front-contact layers 150 and the second back-contact components 124, 126. For example, in the case of a CIGS-type semiconductive photovoltaic layer, the conductive surface of the cell-to-cell via holes is copper-rich, and in the case of a CdTe-type semiconductive photovoltaic layer, the conductive surface of the cell-to-cell via holes is cadmium-rich.

Figure 1F represents a process step in which grooves, also called front-contact grooves 151, are cut through the front-contact layer 150 and extend deep enough to expose continuous lines of at least one of the semiconductive layers 130, 140. During this step the front-contact layers are separated to form a first busbar front-contact component 152, first front-contact components 154, 156, and second front-contact components 156, 158 that are electrically disconnected. At least one of the cell-to-cell via hole 155 per each first front-contact component 154, 156 establishes a series-interconnected electrical path from the first front-contact components 154, 156 mostly overlying the first back-contact components 122, 124 to the second back-contact components 124, 126, thereby realizing three series-interconnected optoelectronic components 104, 106, 108. The process step is often referred to as a scribing or patterning step P3. The patterning step P3 may be done using a mechanical scribing process that uses a mechanical blade or laser, such as a nanometer or picometer pulsed laser.

In some configurations, the scribing steps P2 (for vias) and P3 (for grooves) can advantageously be combined into a single scribing step P (vias + grooves) where the cell-to-cell vias 155 and the grooves 151 are scribed using, for example, at least one laser scribing tool. The processes described herein is advantageous, since a vacuum does not need to be broken between the deposition of the buffer layer 140 and the front-contact layer 150, thereby saving time, energy, and reducing costs. A further advantage is that the processes described herein provide a larger scribing process window that does not require as much precision as conventional methods, thereby allowing the use of less precise and less expensive laser scribing tools, allowing faster scribing steps, and providing higher yields thanks to a lower error rate.

Figure 1G illustrates a cross-section where a grid of metalized front-contact traces 164, 166, 168 are added to electrically connect and/or augment the conductivity of the front-contact components 154, 156, 158. The front-contact traces may be made of silver or other compound that may be screenprinted, electroplated, dispensed, ink-jet printed, or subject to physical vapor deposition (PVD), possibly in multiple steps in combination with metal plating or other treatments. The front-contact traces may extend into via holes so as to further increase conductivity between said front-contact components 154, 156, 158, and respective metalized via hole surfaces 132, 134, 136, 138. The optoelectronic module consequently comprises three optoelectronic cells 104, 106, 108.

### Device Patterning Techniques

In an effort to reduce the adverse effect of cracks formed during one or more of the processing steps described above, or during the normal use of a formed solar cell module that includes a plurality of monolithic photovoltaic devices (e.g., many photovoltaic cells 100), one or more patterning techniques may be used. As noted above, these patterning techniques may include forming one or more scribed regions in a formed or partially formed photovoltaic device to inhibit the migration of cracks or defects to undesirable regions of the formed photovoltaic device and/or reduce or relieve an amount of stress found in the layers of the photovoltaic device.

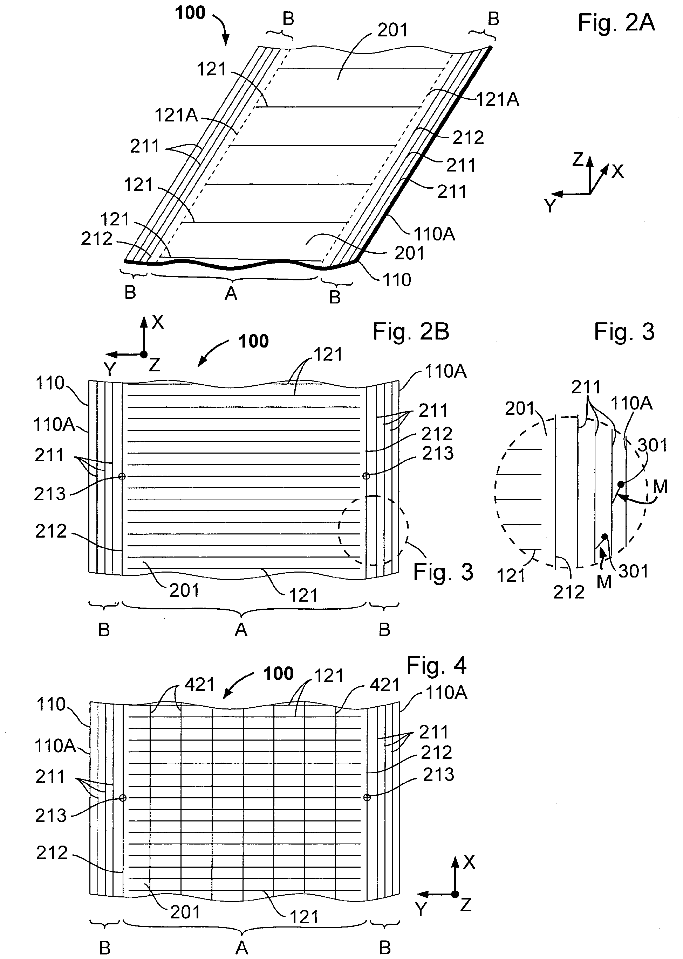

Figure 2A is an isometric view of a patterned portion of a photovoltaic cell 100 according to an embodiment of the disclosure provided herein. As shown in Figure 2A, the substrate 110 may include an active region "A" and two or more edge regions "B" (or border regions B). One will note that edge regions "B" are typically formed around the periphery of the photovoltaic cell 100, and thus the edge regions "B" may extend in both the X and Y-directions, versus just the X-direction shown in Figure 2A.

In a photovoltaic cell 100 the active region "A" generally includes the layers and structure described in conjunction with Figures 1A-1G, which is found above. In one configuration, as illustrated in Figure 2A, the photovoltaic cell 100 includes one or more layers 201 onto which a patterning process is performed to prevent defects in portions of the photovoltaic cell 100 from migrating to the active region A and affecting the photovoltaic device's electrical and mechanical properties. In one embodiment, the patterning process includes the formation of one or more grooves, or one or more scribe lines 211, in a portion of the layer 201 formed in the edge regions B of the photovoltaic cell 100 to prevent the migration of cracks or defects into the active region A from an edge region B. The one or more scribe lines 211 can be spaced apart from the grooves 121 (i.e., the scribe lines 211 and the grooves 121 do not intersect) to further assist in cracks from migrating from the edge region B to the active region A. The patterning process used to form the one or more scribe lines may include the use of a mechanical scribing process, such as by use of a mechanical blade or nanometer or picometer wavelength pulsed laser. The one or more scribe lines 211 may also have a width of between about 40 and 50 µm, such as about 45 µm. The one or more scribe lines 211 may be formed by use of a process similar to the processes used to form the one of the grooves 121, 151 or 155, described above. In embodiments, where the edge regions B extend in both the X and Y-directions, the scribe lines 211 can extend in the X-direction in the edge regions B that extend in the X-direction, and the scribe lines 211 can extend in the Y-direction in the edge regions B that extend in the Y-direction. In these embodiments, the scribe lines 211 can surround the grooves 121 while being spaced apart from the grooves 121.

Figure 2B is a plan view of a portion of a photovoltaic cell 100 according to an embodiment of the disclosure provided herein. In general, the patterning process includes the formation of a plurality of scribe lines 211 in the edge region B of photovoltaic cell 100. In one embodiment, the plurality of scribe lines 211 are each positioned a distance from and parallel to an edge 110A of the substrate 110. The separation between each of the scribe lines 211 may range from 1 mm to 15 mm, such as a separation between about 4 mm and about 10 mm (e.g., 5 mm separation). In some configurations, the number of scribe lines 211 formed in the edge region B may range from 1 to 10, such as about three scribe lines as shown in Figure 2B. The scribe line 211 that is closest to the edge 110A may be positioned a distance in the range of about 5 mm to 30 mm from the edge 110A, such as between about 10 mm and about 15 mm.

In some embodiments, the one or more layers 201 include at least one of the layers 120-160 (Figure 1A) used to form the photovoltaic cell 100. In one embodiment, each of the scribe lines 211 is formed through the back-contact layer 120, so as to expose at least one continuous line of the substrate. In one example, the scribe lines 211 are formed during the P1 patterning step using the same hardware and processes used to form the grooves 121. It has been found that by forming a plurality of scribe lines 211 in the back-contact layer 120 that cracks or defects formed in at least one of the layers 120-160 can be prevented from migrating from the edge region B to the active region A. Thus, the patterning processes described herein can be advantageously used to prevent cracks formed during one of the deposition steps performed after the scribe line 211 formation process, such as, for example, between the P1 and P2 scribing steps, from damaging the formed device, and also do away with the need to develop and tune a scribe line 211 formation process on two or more of the layers that are used to form the photovoltaic cell 100. Thus, without scribe lines 211, a crack that may induce at least one hot spot may spread to the entire photovoltaic cell (the module's entire width) as the crack lengthens.

Figure 3 is a close up view of a portion of the edge region shown in Figure 2B, according to an embodiment of the disclosure provided herein. As illustrated in Figure 3, the scribe lines 211 are used to prevent the defects 301 from migrating along a path "M" towards the active region A, due to generated intrinsic or extrinsic stress found within the edge region B. As noted above, the defects 301 may be formed from handling-generated scratches created during one or more of the processes used to deposit one or more of the layer 120-160 on the substrate 110. Alternately, the defects 301 may be created from material defects formed in one or more of the layer 120-160 formed on the substrate 110.

In some embodiments, the active region "A" may also include an artificial border scribe 212 that is positioned within a portion of the active region A and a distance from and parallel to an edge 110A of the substrate 110. In one embodiment, the artificial border scribes 212 are formed in the back contact layer 120 during the P1 scribing process. In some configurations (not shown), the edges 121A of the grooves 121 may coincide with, and thus connect with the artificial border scribe 212. However, in some embodiments, the artificial border scribes 212 may be formed in during the P2 or P3 scribing processes. The artificial border scribe 212 may be formed by use of a mechanical scribing process, similar to the processes used to form one of the scribe lines 211 or grooves 121, 151 or 155. The artificial border scribe 212 may be used to stop cracks, formed within the border region B from migrating towards the active region A. The separation between the artificial border scribe 212 and scribe lines 211 may range from 5 mm to 50 mm, such as a 10 mm separation.

Figure 4 is a plan view of a portion of a photovoltaic cell 100 according to an embodiment of the disclosure provided herein. In general, the patterning process used to form the photovoltaic device 100 illustrated in Figure 4 includes the formation of a plurality of scribe lines 211 in the edge region B and a plurality of active region scribe lines 421 formed in the layer 201 disposed in the active region A. In some configurations, the plurality of active region scribe lines 421 are each positioned a distance from and parallel to an edge 110A of the substrate 110. In other configurations, the plurality of active region scribe lines 421 are each positioned at an angle to an edge 110A of the substrate 110. The separation between each of the active region scribe line 421 may range from 5 mm to 50 mm, such as a separation of about 10 mm.

In one embodiment, each of the active region scribe lines 421 are formed through the back-contact layer 120, so as to expose at least one continuous line of the substrate. A benefit of forming the active region scribe lines 421 within the back contact layer 120 is that if a shunt occurs within a back contact portion of a device, the hot spot that may result is constrained to the location where the shunt is located. Thus, without forming the active region scribe lines 421 in the back contact layer 120, a hot spot may spread to the entire photovoltaic cell (the module's entire width) as the crack lengthens or as the hot spot induces other cracks to develop and propagate. One will note that the addition of the active region scribe lines 421 will divide up the back-contact components (e.g., components 122, 124, 126 in Figure 1C) so that the lateral conduction of electricity (i.e., conduction in the Y-direction) within each back-contact component is prevented, while the cells remain serially connected in the X-direction. In one configuration, the active region scribe lines 421 are formed during the P1 patterning step. The active region scribe lines 421 may be formed using a mechanical scribing process, such as a process that utilizes a mechanical blade or a nanometer or picometer pulsed laser.

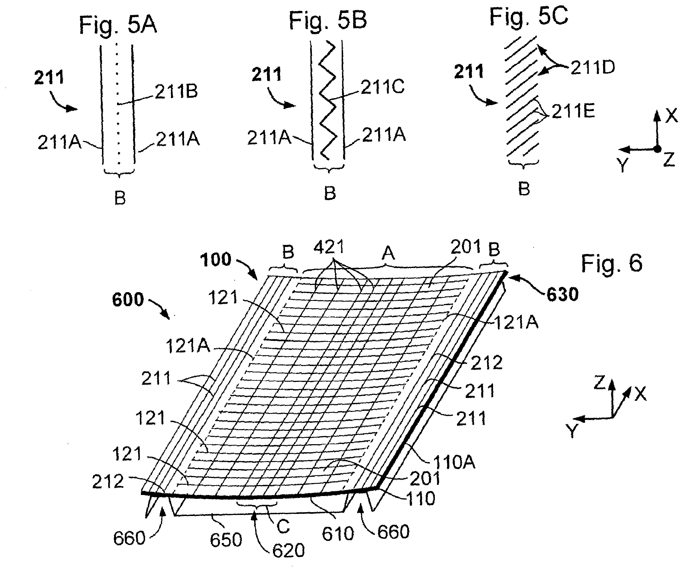

Figures 5A-5C illustrate various patterns of scribe lines that may be formed in the edge region B of a photovoltaic cell 100. Figure 5A illustrates an edge region B that contains an at least three scribe line pattern that may be used to prevent cracks or defects from migration through a region of the photovoltaic cell 100. The edge region B may include two scribe lines 211A and at least one dotted, or dashed, scribe line 211B that are arranged in a parallel relationship that may be aligned relative to an edge of a substrate. It is believed that the dotted scribe line 211B may act as an attractor for cracks or defects that emanate from a continuous scribe line, or other defects found in the various layers of the photovoltaic cell 100. In other words, the dotted scribe line 211B configuration may help to moderate edge stresses and/or act as an attraction for defects that tend to follow lines of stress generated in the formed layers of the photovoltaic cell 100. In one embodiment, the at least one dotted or dashed scribe line 211B may be located between at least two scribe lines 211A.

Figure 5B illustrates an edge region B that contains a three scribe line pattern that includes two scribe lines 211A and one non-linear scribe line 211C that may be formed and aligned relative to an edge of a substrate. The non-linear scribe line 211C may include a plurality of straight and/or curved line segments that are joined together to form a meandering scribe line, such as the zigzag pattern shown in Figure 5B. It is believed that the presence of the non-linear scribe line 211C may help attract cracks or defects that tend to propagate in directions that are not parallel or orthogonal to an edge of the substrate, and/or help relieve stress found in the layers of the photovoltaic cell 100. In one example, the angle of the non-linear scribe lines 211C relative to an edge 110A (Figure 2B) of the substrate, which for example extends in the X-direction, may be between about 40° and about 60°, such as between about 50° and about 55°. In one embodiment, the at least one non linear scribe line 211C may be located between at least two scribe lines 211A.

Figure 5C illustrates an edge region B that contains a scribe line pattern that includes a scribe line 211D that contains an array of scribe line features 211E that are aligned relative to an edge of a substrate, for example relative to an edge 110A (Figure 2B) of the substrate, which extends in the X-direction. The scribe line features 211E of the scribe line 211D may include a plurality of straight and/or curved line segments that are positioned in the edge region B. It is believed that the presence of the scribe line 211D may help attract cracks or defects that tend to propagate in directions that are not parallel or orthogonal to an edge of the substrate, and/or help relieve stress found in the layers of the photovoltaic cell 100. In one example, the angle of the scribe lines 211D relative to an edge 110A of the substrate, which extends in the X-direction, may be between about 40° and about 60°, such as between about 50° and about 55°.

Figure 6 illustrates a photovoltaic construction element 600 that includes at least one photovoltaic device 100 mounted on a back sheet 610, thereby forming a photovoltaic panel 630. The back sheet 610 may for example be flexible or semi-flexible. The back sheet 610 may include at least one layer that is formed from either steel, a polymer, or a fabric material. The back sheet 610 may be attached or bonded to at least one support 650. In one embodiment the support 650 may include at least one supporting point 660. For example, the back sheet 610 may be fastened or bonded to at least one supporting rail 660. The photovoltaic construction element 600 may include at least one photovoltaic panel 630 mounted on at least one support 650. The photovoltaic construction element 600 may for example be disposed on a roof or a facade of a building.

The photovoltaic device 100 may be curved by design or because of stresses formed in the photovoltaic device cause it to bend. Bending may cause a region of higher curvature 620 to form. Bending may cause greater stresses in the material layers found in the region of higher curvature 620 than in other regions of the photovoltaic device. These greater stresses may increase the risk that cracks may form or propagate within the region of higher curvature 620. In one embodiment, as shown in Figure 6, the region of higher curvature 620 causes tension within the back contact layer 120. In an effort to relieve stress within the region of higher curvature 620, active region scribe lines 421 can be formed within a region C to prevent the movement of cracks within this region. In general, the active region scribe lines 421 are closer to each other than other scribe line patterns formed in other regions of the photovoltaic device 100. Positioning the active region scribe lines 421 closer together may be advantageous in regions where the back sheet 610 is deformed into a concave shape, with the deposited film layers being positioned on the side of the photovoltaic device 100 that contains the concave region. A photovoltaic device 100 may include a plurality of regions C, where active region scribe lines 421 are, as a rule or on average, positioned closer to each other than in other regions of the photovoltaic device. In one embodiment, the average spacing of the active region scribe lines 421 in the curved region C is less than the average spacing of the active region scribe lines 421 in other areas of the active region A. In some configurations, a photovoltaic device may include at least one region C where the active region scribe lines 421 are positioned progressively closer to each other, for example, as a function of the distribution of stresses expected in the back contact layer 120 or as a function of the existing or foreseen curvature of the back contact layer 120.

A photovoltaic device 100 may include at least one region C to increase the longevity of the formed photovoltaic device that includes a curved region. A photovoltaic construction element 600 having at least one region C may have a longer life than a conventional photovoltaic device that is deformed by exposure, for example, to snow, wind, or heat (e.g., leading to thermal expansion), such as may be experienced when being used on a roof or a building facade. Another embodiment of a photovoltaic construction element 600 may include a flexible back sheet that includes an architectural fabric, fastened to a plurality of supporting points 660.

While the foregoing is directed to embodiments of the present disclosure, other and further embodiments of the disclosure may be devised without departing from the basic scope thereof, and the scope thereof is determined by the claims that follow.

## Claims

1. A thin-film optoelectronic module device (100), comprising:
a substrate (110) that has an edge (110A) that extends in a first direction (X), an active region (A) and an edge region (B) that is disposed between the edge (110A) and the active region (A);
a semiconductive photovoltaic layer (130); and
a conductive back-contact layer (120) that is disposed between the substrate (110) and the semiconductive photovoltaic layer (130), wherein the conductive back-contact layer (120) is disposed within at least a portion of the active region (A) and the edge region (B), and the conductive back-contact layer (120) comprises:
a plurality of isolating back-contact grooves (121) that are aligned in a second direction (Y) and are disposed within the active region (A), wherein the second direction (Y) is at an angle to the first direction (X); and
one or more scribe lines (211) that are formed in the first direction (X) by use of a laser before depositing the semiconductive photovoltaic layer on the conductive back-contact layer, wherein the one or more scribe lines (211) are disposed within the edge region (B).

2. The thin-film optoelectronic device (100) of claim 1, wherein the one or more scribe lines (211) are spaced apart from the plurality of isolating back-contact grooves (121).

3. The thin-film optoelectronic module device (100) of claim 1, further comprising an artificial border scribe which is an additional scribe line (212) that is aligned parallel to the first direction (X) and is positioned within the active region (A).

4. The thin-film optoelectronic module device (100) of claim 1, further comprising a plurality of active region scribe lines (421) that are formed in the conductive back-contact layer (120) and aligned in a spaced apart relationship that is parallel to the first direction (X), wherein the active region scribe lines (421) are positioned within the active region (A), and cross the isolating back-contact grooves (121).

5. The thin-film optoelectronic module device (100) of claim 4, further comprising an artificial border scribe which is an additional scribe line (212) that is parallel to the first direction (X) and is positioned within the active region (A).

6. A method of forming a thin-film optoelectronic module device (100), comprising:
depositing a conductive back-contact layer (120) on a substrate (110) having an edge (110A) that extends in a first direction (X), wherein the deposited conductive back-contact layer (120) is disposed over at least a portion of an active region (A) and an edge region (B) of the substrate (110), and the edge region (B) is disposed between the active region (A) and an edge of the substrate (110A);
forming a plurality of isolating back-contact grooves (121), which are aligned in a second direction (Y), within the active region (A) of the deposited conductive back-contact layer (120), wherein the second direction (Y) is at an angle to the first direction (X);
forming one or more scribe lines (211), which are aligned in the first direction (X), within the edge region (B) of the deposited conductive back-contact layer (120); and
then depositing a semiconductive photovoltaic layer (130) over the conductive back-contact layer (120).

7. The method of claim 6, wherein the one or more scribe lines (211) are spaced apart from the plurality of isolating back-contact grooves (121).

8. The method of claim 6, further comprising forming an artificial border scribe which is an additional scribe line (212) that is parallel to the first direction (X) and is positioned within the active region (A).

9. The method of claim 6, further comprising:
forming a plurality of active region scribe lines (421) within the conductive back-contact layer (120) disposed within the active region (A), wherein the plurality of active region scribe lines (421) are aligned in a spaced apart relationship that is parallel to the first direction (X), and each of the active region scribe lines (421) cross the formed one or more isolating back-contact grooves (121).

10. The method of claim 9, further comprising forming an artificial border scribe which is an additional scribe line (212) that is parallel to the first direction (X) and is positioned within the active region (A).

11. A thin-film optoelectronic module device (100) according to any of the claims 1 to 5, comprising:
a substrate (110) that has an edge (110A) that extends in a first direction (X), an active region (A), exhibiting a curved region (C) and an edge region (B) that is disposed between the edge (110A) and the active region (A);
a semiconductive photovoltaic layer (130); and
a conductive back-contact layer (120)that is disposed between the substrate (110) and the semiconductive photovoltaic layer (130), wherein the conductive back-contact layer (120) is disposed within at least a portion of the active region (A), the curved region (C) and the edge region (B), and the conductive back-contact layer (120) comprises:
a plurality of isolating back-contact grooves (121) that are aligned in a second direction (Y) and are disposed within the active region (A), wherein the second direction (Y) is at an angle to the first direction (X);
one or more scribe lines (211) that are formed in the first direction (X), wherein the one or more scribe lines (211) are disposed within the edge region (B); and
a plurality of active region scribe lines (421) that are aligned parallel to the first direction (X) and are formed within the active region (A) and the curved region (C), wherein the average spacing of the active region scribe lines (421) in the curved region (C) is less than the average spacing of the active region scribe lines (421) in the active region (A).

12. The thin-film optoelectronic device (100) of claim 11, wherein the one or more scribe lines (211) are spaced apart from the plurality of isolating back-contact grooves (121).

13. The thin-film optoelectronic module device (100) of claim 11, further comprising an artificial border scribe which is an additional scribe line (212) that is aligned parallel to the first direction (X) and is positioned within the active region (A).

14. A method of forming a thin-film optoelectronic module device (100) according to any of the claims 6 to 10, comprising:
depositing a conductive back-contact layer (120) on a substrate (110) having an edge (110A) that extends in a first direction (X), wherein the deposited conductive back-contact layer (120) is disposed over at least a portion of an active region (A), a curved region (C) of the active region (A) and an edge region (B) of the substrate (110), and the edge region (B) is disposed between the active region (A) and an edge of the substrate (110A);
forming a plurality of isolating back-contact grooves (121), which are aligned in a second direction (Y), within the active region (A) of the deposited conductive back-contact layer (120), wherein the second direction (Y) is at an angle to the first direction (X);
forming a plurality of active region scribe lines (421) within the conductive back-contact layer (120) disposed within the active region (A) and the curved region (C), wherein the plurality of active region scribe lines (421) are aligned in a spaced apart relationship that is parallel to the first direction (X), and the average spacing of the active region scribe lines (421) in the curved region (C) is less than the average spacing of the active region scribe lines (421) in the active region (A);
forming one or more scribe lines (211), which are aligned in the first direction (X), within the edge region (B) of the deposited conductive back-contact layer (120); and
then depositing a semiconductive photovoltaic layer (130) over the conductive back-contact layer (120).

15. The method of claim 14, wherein the one or more scribe lines (211) are spaced apart from the plurality of isolating back-contact grooves (121).

## Patentansprüche

1. Optoelektronisches Dünnschichtmodul (100), umfassend:
ein Substrat (110) mit einer Kante (110A), die sich in einer ersten Richtung (X) erstreckt, einem aktiven Bereich (A) und einem Kantenbereich (B), der zwischen der Kante (110A) und dem aktiven Bereich (A) angeordnet ist;
eine halbleitende Photovoltaikschicht (130); und
eine leitende Rückkontaktschicht (120), die zwischen dem Substrat (110) und der halbleitenden Photovoltaikschicht (130) angeordnet ist, wobei die leitende Rückkontaktschicht (120) in mindestens einem Teil des aktiven Bereichs (A) angeordnet ist und der Randbereich (B) und die leitende Rückkontaktschicht (120) umfasst:
mehrere isolierende Rückkontaktnuten (121), die in einer zweiten Richtung (Y) ausgerichtet sind und innerhalb des aktiven Bereichs (A) angeordnet sind, wobei die zweite Richtung (Y) in einem Winkel zur ersten Richtung (X) liegt; und
eine oder mehrere gravierte Linien (211), die in der ersten Richtung (X) unter Verwendung eines Lasers gebildet werden, bevor die halbleitende Photovoltaikschicht auf der leitenden Rückkontaktschicht abgeschieden wird, wobei die eine oder mehreren gravierte Linien (211) darin angeordnet sind der Randbereich (B).

2. Optoelektronische Dünnschichtvorrichtung (100) nach Anspruch 1, wobei die eine oder mehreren gravierte Linien (211) von den mehreren isolierenden Rückkontaktnuten (121) beabstandet sind.

3. Optoelektronisches Dünnschichtmodul (100) nach Anspruch 1, ferner umfassend einen künstlichen Randschreiber, der eine zusätzliche gravierte Linie (212) ist, die parallel zur ersten Richtung (X) ausgerichtet ist und innerhalb des aktiven Bereichs positioniert ist (A).

4. Optoelektronische Dünnschichtmodulvorrichtung (100) nach Anspruch 1, ferner umfassend mehrere gravierte Linien (421) für den aktiven Bereich, die in der leitenden Rückkontaktschicht (120) ausgebildet und in einer beabstandeten Beziehung ausgerichtet sind, die parallel zu der ersten Richtung (X), wobei die gravierte Linien (421) des aktiven Bereichs innerhalb des aktiven Bereichs (A) positioniert sind und die isolierenden Rückkontaktnuten (121) kreuzen.

5. Optoelektronische Dünnschichtmodulvorrichtung (100) nach Anspruch 4, ferner umfassend einen künstlichen Randschreiber, der eine zusätzliche gravierte Linie (212) ist, die parallel zur ersten Richtung (X) ist und innerhalb des aktiven Bereichs (A) positioniert ist.

6. Verfahren zum Bilden einer optoelektronischen Dünnschichtmodulvorrichtung (100), umfassend:
Abscheiden einer leitenden Rückkontaktschicht (120) auf einem Substrat (110) mit einer Kante (110A), die sich in einer ersten Richtung (X) erstreckt, wobei die abgeschiedene leitende Rückkontaktschicht (120) über mindestens einen Teil angeordnet ist eines aktiven Bereichs (A) und eines Randbereichs (B) des Substrats (110), und der Kantenbereich (B) ist zwischen dem aktiven Bereich (A) und einer Kante des Substrats (110A) angeordnet;
Bilden einer Vielzahl von isolierenden Rückkontaktnuten (121), die in einer zweiten Richtung (Y) ausgerichtet sind, innerhalb des aktiven Bereichs (A) der abgeschiedenen leitenden Rückkontaktschicht (120), wobei die zweite Richtung (Y) ist in einem Winkel zur ersten Richtung (X);
Bilden einer oder mehrerer gravierte Linien (211), die in der ersten Richtung (X) ausgerichtet sind, innerhalb des Randbereichs (B) der abgeschiedenen leitenden Rückkontaktschicht (120); und
dann Abscheiden einer halbleitenden Photovoltaikschicht (130) über der leitenden Rückkontaktschicht (120).

7. Verfahren nach Anspruch 6, wobei die eine oder mehreren gravierte Linien (211) von den mehreren isolierenden Rückkontaktnuten (121) beabstandet sind.

8. Verfahren nach Anspruch 6, ferner umfassend das Bilden eines künstlichen Randschreibers, der eine zusätzliche Schreiberlinie (212) ist, die parallel zur ersten Richtung (X) ist und innerhalb des aktiven Bereichs (A) positioniert ist.

9. Verfahren nach Anspruch 6, ferner umfassend:
Bilden einer Vielzahl von gravierte Linien (421) für den aktiven Bereich innerhalb der leitenden Rückkontaktschicht (120), die innerhalb des aktiven Bereichs (A) angeordnet ist, wobei die gravierte Linien für den aktiven Bereich (421) in einer beabstandeten Beziehung ausgerichtet sind, die parallel zu der ersten Richtung (X) ist, und jede der gravierte Linien (421) des aktiven Bereichs kreuzen die gebildete eine oder mehrere isolierende Rückkontaktnuten (121).

10. Verfahren nach Anspruch 9, ferner umfassend das Bilden eines künstlichen Randschreibers, der eine zusätzliche Schreiberlinie (212) ist, die parallel zur ersten Richtung (X) ist und innerhalb des aktiven Bereichs (A) positioniert ist.

11. Optoelektronisches Dünnschichtmodul (100) nach einem der Ansprüche 1 bis 5, umfassend:
ein Substrat (110) mit einer Kante (110A), die sich in einer ersten Richtung (X) erstreckt, einem aktiven Bereich (A), der einen gekrümmten Bereich (C) aufweist, und einem Kantenbereich (B), der zwischen der Kante (110A) und der aktive Bereich (A);
eine halbleitende Photovoltaikschicht (130); und
eine leitende Rückkontaktschicht (120), die zwischen dem Substrat (110) und der halbleitenden Photovoltaikschicht (130) angeordnet ist, wobei die leitende Rückkontaktschicht (120) in mindestens einem Teil des aktiven Bereichs (A) angeordnet ist umfasst der gekrümmte Bereich (C) und der Randbereich (B) und die leitende Rückkontaktschicht (120):
mehrere isolierende Rückkontaktnuten (121), die in einer zweiten Richtung (Y) ausgerichtet sind und innerhalb des aktiven Bereichs (A) angeordnet sind, wobei die zweite Richtung (Y) in einem Winkel zur ersten Richtung (X) liegt;
eine oder mehrere gravierte Linien (211), die in der ersten Richtung (X) gebildet sind, wobei die eine oder mehreren gravierte Linien (211) innerhalb des Randbereichs (B) angeordnet sind; und
eine Vielzahl von Aktivbereich-Graviertelinien (421), die parallel zur ersten Richtung (X) ausgerichtet sind und innerhalb des aktiven Bereichs (A) und des gekrümmten Bereichs (C) gebildet sind, wobei der durchschnittliche Abstand der gravierte Linien im Aktivbereich (421) im gekrümmten Bereich (C) ist kleiner als der durchschnittliche Abstand der gravierte Linien (421) des aktiven Bereichs im aktiven Bereich (A).

12. Optoelektronische Dünnschichtvorrichtung (100) nach Anspruch 11, wobei die eine oder mehreren gravierte Linien (211) von den mehreren isolierenden Rückkontaktnuten (121) beabstandet sind.

13. Optoelektronisches Dünnschichtmodul (100) nach Anspruch 11, ferner umfassend eine zusätzliche gravierte Linien (212), die parallel zur ersten Richtung (X) ausgerichtet ist und innerhalb des aktiven Bereichs (A) positioniert ist.

14. Verfahren zum Bilden einer optoelektronischen Dünnschichtmodulvorrichtung (100) nach einem der Ansprüche 6 bis 10, umfassend:
Abscheiden einer leitenden Rückkontaktschicht (120) auf einem Substrat (110) mit einer Kante (110A), die sich in einer ersten Richtung (X) erstreckt, wobei die abgeschiedene leitende Rückkontaktschicht (120) über mindestens einen Teil angeordnet ist eines aktiven Bereichs (A), eines gekrümmten Bereichs (C) des aktiven Bereichs (A) und eines Kantenbereichs (B) des Substrats (110) und des Randbereichs (B) ist zwischen dem aktiven Bereich (A) angeordnet und eine Kante des Substrats (110A);
Bilden einer Vielzahl von isolierenden Rückkontaktnuten (121), die in einer zweiten Richtung (Y) ausgerichtet sind, innerhalb des aktiven Bereichs (A) der abgeschiedenen leitenden Rückkontaktschicht (120), wobei die zweite Richtung (Y) ist in einem Winkel zur ersten Richtung (X);
Bilden einer Vielzahl von gravierte Linien (421) des aktiven Bereichs innerhalb der leitenden Rückkontaktschicht (120), die innerhalb des aktiven Bereichs (A) und des gekrümmten Bereichs (C) angeordnet ist, wobei die mehreren gravierte Linien (421) des aktiven Bereichs ausgerichtet sind in einer beabstandeten Beziehung, die parallel zur ersten Richtung (X) ist, und der durchschnittliche Abstand der gravierte Linien des aktiven Bereichs (421) in dem gekrümmten Bereich (C) ist kleiner als der durchschnittliche Abstand der gravierte Linien des aktiven Bereichs (421) in der aktiven Region (A);
Bilden einer oder mehrerer gravierte Linien (211), die in der ersten Richtung (X) ausgerichtet sind, innerhalb des Randbereichs (B) der abgeschiedenen leitenden Rückkontaktschicht (120); und
dann Abscheiden einer halbleitenden Photovoltaikschicht (130) über der leitenden Rückkontaktschicht (120).

15. Verfahren nach Anspruch 14, wobei die eine oder mehreren gravierte Linien (211) von den mehreren isolierenden Rückkontaktnuten (121) beabstandet sind.

## Revendications

1. Dispositif de module optoélectronique à couche mince (100), comprenant :
un substrat (110) qui a un bord (110A) qui s'étend dans une première direction (X), une région active (A) et une région de bord (B) qui est disposée entre le bord (110A) et la région active (A) ;
une couche photovoltaïque semi-conductrice (130) ; et
une couche conductrice de contact arrière (120) qui est disposée entre le substrat (110) et la couche photovoltaïque semi-conductrice (130), dans laquelle la couche conductrice de contact arrière (120) est disposée dans au moins une partie de la région active (A) et la région de bord (B), et la couche conductrice de contact arrière (120) comprend:
une pluralité de rainures de contact arrière isolantes (121) qui sont alignées dans une seconde direction (Y) et sont disposées dans la région active (A), dans laquelle la deuxième direction (Y) est à un angle par rapport à la première direction (X) ; et
une ou plusieurs lignes de gravage (211) qui sont formées dans la première direction (X) à l'aide d'un laser avant de déposer la couche photovoltaïque semi-conductrice sur la couche de contact arrière conductrice, la ou les lignes de gravage (211) étant disposées à l'intérieur la région de bord (B).

2. Dispositif optoélectronique à couche mince (100) selon la revendication 1, dans lequel la ou les lignes de gravage (211) sont espacées de la pluralité de rainures de contact arrière isolantes (121).

3. Dispositif de module optoélectronique à couche mince (100) selon la revendication 1, comprenant en outre un marqueur de bordure artificielle qui est une ligne de marquage supplémentaire (212) qui est alignée parallèlement à la première direction (X) et est positionnée dans la région active (A).

4. Dispositif de module optoélectronique à couche mince (100) selon la revendication 1, comprenant en outre une pluralité de lignes de gravage de région active (421) qui sont formées dans la couche de contact arrière conductrice (120) et alignées dans une relation espacée qui est parallèle à la première direction (X), dans laquelle les lignes de gravage de région active (421) sont positionnées à l'intérieur de la région active (A) et traversent les rainures de contact arrière isolantes (121).

5. Dispositif de module optoélectronique à couche mince (100) selon la revendication 4, comprenant en outre un gravage de bordure artificielle qui est une ligne de gravage supplémentaire (212) qui est parallèle à la première direction (X) et est positionnée dans la région active (A).

6. Procédé de formation d'un dispositif de module optoélectronique à couche mince (100), comprenant :
déposer une couche de contact arrière conductrice (120) sur un substrat (110) ayant un bord (110A) qui s'étend dans une première direction (X), dans lequel la couche de contact arrière conductrice déposée (120) est disposée sur au moins une partie d'une région active (A) et d'une région de bord (B) du substrat (110), et la région de bord (B) est disposée entre la région active (A) et un bord du substrat (110A) ;
former une pluralité de rainures de contact arrière isolantes (121), qui sont alignées dans une seconde direction (Y), à l'intérieur de la région active (A) de la couche conductrice de contact arrière déposée (120), dans laquelle la deuxième direction (Y) est à un angle par rapport à la première direction (X) ;
former une ou plusieurs lignes de gravage (211), qui sont alignées dans la première direction (X), à l'intérieur de la région de bord (B) de la couche conductrice de contact arrière déposée (120) ; et
ensuite déposer une couche photovoltaïque semi-conductrice (130) sur la couche conductrice de contact arrière (120).

7. Procédé selon la revendication 6, dans lequel la ou les lignes de gravage (211) sont espacées de la pluralité de rainures de contact arrière isolantes (121).

8. Procédé selon la revendication 6, comprenant en outre la formation d'un gravage de bordure artificielle qui est une ligne de gravage supplémentaire (212) qui est parallèle à la première direction (X) et est positionnée à l'intérieur de la région active (A).

9. Procédé selon la revendication 6, comprenant en outre :
former une pluralité de lignes de gravage de région active (421) à l'intérieur de la couche conductrice de contact arrière (120) disposée à l'intérieur de la région active (A), dans laquelle la pluralité de lignes de gravage de région active (421) sont alignées dans une relation espacée qui est parallèle à la première direction (X), et chacune des lignes de gravage de région active (421) croisent la ou les rainures isolées de contact arrière formées (121).

10. Procédé selon la revendication 9, comprenant en outre la formation d'un marqueur de bordure artificielle qui est une ligne de gravage supplémentaire (212) qui est parallèle à la première direction (X) et est positionnée dans la région active (A).

11. Dispositif de module optoélectronique à couche mince (100) selon l'une quelconque des revendications 1 à 5, comprenant :
un substrat (110) qui a un bord (110A) qui s'étend dans une première direction (X), une région active (A), présentant une région incurvée (C) et une région de bord (B) qui est disposée entre le bord (110A) et la région active (A) ;
une couche photovoltaïque semi-conductrice (130) ; et
une couche conductrice de contact arrière (120) qui est disposée entre le substrat (110) et la couche photovoltaïque semi-conductrice (130), dans laquelle la couche conductrice de contact arrière (120) est disposée dans au moins une partie de la région active (A), la région incurvée (C) et la région de bord (B), et la couche conductrice de contact arrière (120) comprennent :
une pluralité de rainures de contact arrière isolantes (121) qui sont alignées dans une seconde direction (Y) et sont disposées dans la région active (A), dans laquelle la deuxième direction (Y) est à un angle par rapport à la première direction (X) ;
une ou plusieurs lignes de gravage (211) qui sont formées dans la première direction (X), dans lequel la ou les lignes de gravage (211) sont disposées à l'intérieur de la région de bord (B) ; et
une pluralité de lignes de gravage de région active (421) qui sont alignées parallèlement à la première direction (X) et sont formées à l'intérieur de la région active (A) et de la région incurvée (C), où l'espacement moyen des lignes de gravage de région active (421) dans la région incurvée (C) est inférieure à l'espacement moyen des lignes de gravage de la région active (421) dans la région active (A).

12. Dispositif optoélectronique à couche mince (100) selon la revendication 11, dans lequel la ou les lignes de gravage (211) sont espacées de la pluralité de rainures de contact arrière isolantes (121).

13. Dispositif de module optoélectronique à couche mince (100) selon la revendication 11, comprenant en outre une ligne de gravage supplémentaire (212) qui est alignée parallèlement à la première direction (X) et est positionnée dans la région active (A).

14. Procédé de formation d'un dispositif de module optoélectronique à couche mince (100) selon l'une quelconque des revendications 6 à 10, comprenant :
déposer une couche de contact arrière conductrice (120) sur un substrat (110) ayant un bord (110A) qui s'étend dans une première direction (X), dans lequel la couche de contact arrière conductrice déposée (120) est disposée sur au moins une partie d'une région active (A), d'une région courbe (C) de la région active (A) et d'une région de bord (B) du substrat (110), et la région de bord (B) est disposée entre la région active (A) et un bord du substrat (110A) ;
former une pluralité de rainures de contact arrière isolantes (121), qui sont alignées dans une seconde direction (Y), à l'intérieur de la région active (A) de la couche conductrice de contact arrière déposée (120), dans laquelle la deuxième direction (Y) est à un angle par rapport à la première direction (X) ;
former une pluralité de lignes de gravage de région active (421) à l'intérieur de la couche conductrice de contact arrière (120) disposée à l'intérieur de la région active (A) et de la région incurvée (C), dans laquelle la pluralité de lignes de gravage de région active (421) sont alignées dans une relation espacée qui est parallèle à la première direction (X), et l'espacement moyen des lignes de gravage de la région active (421) dans la région incurvée (C) est inférieur à l'espacement moyen des lignes de gravage de la région active (421) dans la région active (A) ;
former une ou plusieurs lignes de gravage (211), qui sont alignées dans la première direction (X), à l'intérieur de la région de bord (B) de la couche conductrice de contact arrière déposée (120) ; et
ensuite déposer une couche photovoltaïque semi-conductrice (130) sur la couche conductrice de contact arrière (120).

15. Procédé selon la revendication 14, dans lequel la ou les lignes de gravage (211) sont espacées de la pluralité de rainures de contact arrière isolantes (121).
